Europäisches Patentamt

European Patent Office

Office européen des brevets

(19)

(11) **EP 0 488 893 B1**

(12) **FASCICULE DE BREVET EUROPEEN**

(45) Date de publication et mention
de la délivrance du brevet:
**12.02.1997 Bulletin 1997/07**

(51) Int Cl.[6]: **H03K 5/24**, G11C 7/00

(21) Numéro de dépôt: **91403219.8**

(22) Date de dépôt: **27.11.1991**

(54) **Procédé et dispositif de transfert de signaux binaires différentiels et application aux additionneurs à sélection de retenue**

Verfahren und Vorrichtung zur Übertragung binärer Differenzsignale und Verwendung in Carry-Select-Addierern

Method and device for conveying binary differential signals and application in carry select adders

(84) Etats contractants désignés:
**DE FR GB IT NL**

(30) Priorité: **30.11.1990 FR 9015057**

(43) Date de publication de la demande:
**03.06.1992 Bulletin 1992/23**

(73) Titulaire: **BULL S.A.**
**78430 Louveciennes (FR)**

(72) Inventeur: **Neu, Georges**
**F-75116 Paris (FR)**

(74) Mandataire: **Colombe, Michel et al**
**Direction de la Propriété Intellectuelle BULL SA**
**Poste courrier:LV 59C18**
**68 route de Versailles**
**78430 Louveciennes (FR)**

(56) Documents cités:
EP-A- 0 264 933         DE-B- 2 317 497
US-A- 4 634 890        US-A- 4 932 002

• INTERNATIONAL JOURNAL OF ELECTRONICS, vol. 64, no. 3, mars 1988, pages 409-415, Londres, GB; C.P. CHONG et al.: "A high-resolution CMOS comparator"
• K. HWANG: "Computer arithmetic-principle, architecture and design", 1979, pages 80-84, John Wiley and Sons, New York, US

**Description**

L'invention concerne le problème général du transfert de signaux électriques de type différentiel. Ce problème se pose pour réaliser des montages électriques comportant des circuits qui élaborent des signaux logiques dont la valeur est définie par le signe de la différence de potentiel entre deux lignes de sortie de ces circuits.

Ces signaux sont généralement appliqués à l'entrée d'autres circuits faisant partie du montage et ces circuits peuvent eux-même fournir des signaux différentiels destinés à d'autres circuits placés en aval.

Ces signaux de sortie sont élaborés par un étage de sortie capable de fournir une puissance suffisante pour alimenter les étages d'entrée des circuits en aval. Pour transférer des signaux binaires d'une première ligne unique vers une autre ligne, le document DE-A-2317 497 décrit un circuit d'évaluation constitué d'au moins un inverseur. Le court circuitage de l'entrée et de la sortie du circuit d'évaluation réalise une précharge de la première ligne. Cependant, dans le cas de signaux binaires différentiels, on utilise souvent des amplificateurs différentiels comme étages de sortie.

Pour des raisons de performance, en particulier en technologie MOS ou CMOS, il est courant d'utiliser des circuits dits "à précharge". Pendant une première phase de "précharge" les lignes différentielles sont chargées à une tension déterminée puis, pendant une seconde phase d'"évaluation", les lignes sont placées à des tensions définissant un état logique fonction des signaux d'entrée appliqués au circuit. Ainsi, dans le cas de signaux différentiels, lorsque l'une des lignes est évaluée à une première tension, par exemple la tension d'alimentation, l'autre ligne est placée à une seconde tension, par exemple la tension de masse. Dans ce cas, on cherche à précharger les lignes à une tension voisine de la moitié de la tension d'alimentation afin de réduire le temps de commutation des lignes. La précharge est alors généralement réalisée au moyen d'un circuit de précharge qui, sous la commande d'un signal de précharge, met en communication les lignes avec une source d'alimentation auxiliaire fournissant une tension moitié de la tension d'alimentation. Habituellement, le circuit de précharge comporte un circuit d'égalisation pour court-circuiter les deux lignes afin d'assurer l'égalité des tensions de précharge de ces lignes.

Cependant, cette solution classique présente l'inconvénient de nécessiter une source auxiliaire d'alimentation dont la tension est difficile à ajuster précisément, en particulier dans le cas des circuits intégrés. En effet, les circuits intégrés présentent des dispersions de fabrication importantes et il n'est pas facile, après fabrication, de modifier les caractéristiques de certains de leur sous-ensembles.

Le document US-A-4932 002 décrit une cellule constituée d'un double inverseur sur le modèle d'un élément mémoire connecté en parallèle sur deux lignes différentielles. Le court-circuitage des lignes différentielles place la cellule à mi-chemin entre le potentiel haut et le potentiel bas. Ceci a pour effet de précharger les lignes différentielles. Cependant, ce montage ne permet pas de précharger simultanément une première paire de lignes différentielles sur laquelle sont présents des signaux et une seconde paire de lignes différentielles distincte destinée à recevoir les signaux transférés à partir de la première paire de lignes différentielles.

Aussi l'invention a pour but de résoudre les problèmes posés par l'état de la technique et a pour objet un procédé pour transférer une information binaire de type différentiel présente sur deux premières lignes de bit vers deux secondes lignes de bit distinctes desdites premières lignes de bit par l'intermédiaire d'un amplificateur différentiel, ledit procédé comportant une phase de précharge suivie d'une phase d'évaluation desdites premières lignes de bit.

Le procédé qui vient d'être décrit peut toutefois présenter une difficulté liée à la consommation de l'amplificateur pendant la précharge. En effet, pendant cette phase, l'amplificateur est en court-circuit et débite sur ses propres impédances internes. Ainsi, dans le cas où l'amplificateur a de faibles impédances internes, par exemple dans un montage nécessitant un amplificateur relativement puissant, la consommation peut devenir importante et entraîne une élévation de température sensible. Ceci a notamment pour conséquence une dégradation des performances provoquée par une augmentation du temps de commutation des composants, tels que les transistors MOS, qui font partie du circuit intégré. Le même problème peut se poser si on utilise un grand nombre de circuits de ce type dans un même circuit intégré.

Pour remédier à cet inconvénient dans les cas précités, selon l'invention, le procédé est en outre caractérisé en ce qu'il consiste à utiliser un premier amplificateur différentiel possédant de fortes impédances internes de sortie et un second amplificateur différentiel à trois états possédant de faibles impédances internes de sortie, en ce que les entrées, respectivement, les sorties desdits premier et second amplificateurs différentiels sont branchées en parallèle et en ce que ledit second amplificateur différentiel est mis à l'état de haute impédance pendant ladite phase de précharge.

Outre l'économie d'une source d'alimentation auxiliaire, cette solution présente la particularité avantageuse que la tension appliquée pendant la précharge sur les lignes d'entrée de l'amplificateur différentiel s'ajuste automatiquement à un niveau qui place l'amplificateur dans son état d'instabilité maximale, indépendamment des dispersions de fabrication. Il en résulte que le délai de commutation de l'amplificateur lors de l'évaluation suivante est minimum.

Généralement, les signaux différentiels ainsi amplifiés sont appliqués à l'entrée d'autres circuits nécessitant également une précharge. Aussi, il convient d'effectuer également la précharge convenable des lignes de sortie de l'amplificateur et selon une caractéristique supplémentaire de l'invention, le procédé est en outre caractérisé en ce que pendant la phase de précharge, les secondes lignes de bit sont mises en court-circuit entre elles.

L'invention concerne également un circuit électronique pour la mise en oeuvre du procédé. Le circuit électronique selon l'invention comporte au moins une entrée binaire de type différentielle constituée de deux premières lignes de bit reliées à l'entrée d'un amplificateur différentiel et une sortie binaire de même type. Les lignes de bit sont préchargées à une tension déterminée pendant une phase de précharge suivie d'une phase d'évaluation et ce circuit est caractérisé en ce que l'amplificateur différentiel est constitué d'un premier amplificateur différentiel à fortes impédances internes de sortie et d'un second amplificateur différentiel à trois états à faibles impédances internes de sortie, les entrées, respectivement, les sorties desdits premier et second amplificateurs différentiels étant branchées en parallèle, en ce qu'il comprend des premiers moyens pour court-circuiter lesdites deux premières lignes de bit et des seconds moyens pour court-circuiter au moins une des lignes de sortie de l'amplificateur différentiel avec au moins une des lignes de bit, lesdits premier et second moyens étant activés pendant ladite phase de précharge et désactivés pendant ladite phase d'évaluation et en ce que ledit second amplificateur différentiel est mis à l'état de haute impédance pendant ladite phase de précharge.

Selon un autre aspect du circuit selon l'invention, il est caractérisé en ce qu'il comprend des troisièmes moyens pour court-circuiter entre elles les deux lignes de sortie de l'amplificateur différentiel.

D'autres caractéristiques et détails de réalisation en technologie CMOS du circuit selon l'invention apparaîtront dans la suite de la description.

Le procédé et le circuit qui viennent d'être présentés trouvent une application particulièrement intéressante dans les montages utilisant une pluralité de circuits montés en cascade, chaque circuit fournissant à des circuits placés en aval des informations binaires de type différentielles. En effet, la rapidité de fonctionnement de ce genre de montage est grandement conditionnée par la rapidité de la transmission des signaux de sortie d'un circuit aux circuits en aval. Il est donc important que les étages de sortie commutent rapidement. Ceci permet, dans le cas d'un montage synchrone, d'augmenter la fréquence d'horloge.

Aussi l'invention également a pour objet un montage comprenant une pluralité de circuits branchés en cascade, chaque circuit fournissant en sortie à au moins un circuit placé en aval au moins une information binaire de type différentiel, caractérisé en ce que chacun desdits circuits contient circuit électronique selon l'invention défini précédemment.

Dans ce type de montage, il importe que les phases de précharge et d'évaluation des circuits se produisent dans un ordre convenable pour éviter de déclencher l'évaluation d'un circuit avant que le ou les circuits en amont ne soient eux-même évalués.

Dans ce but, le montage selon l'invention est en outre caractérisé en ce qu'il comporte une pluralité d'inverseurs branchés en cascade et associés respectivement aux circuits électroniques et aux amplificateurs différentiels constituant ledit montage, en ce que le premier desdits inverseurs reçoit en entrée un signal d'horloge et en ce que lesdites phases de précharge et d'évaluation d'un amplificateur différentiel sont commandées par les signaux d'entrée et/ou de sortie de l'inverseur associé audit amplificateur différentiel.

Il existe de nombreux exemples de montages auxquels l'invention peut s'appliquer. Il peut s'agir en particulier des circuits conçus de façon modulaire. Cette disposition est normalement recherchée en vue d'une réalisation sous forme de circuit intégré car la régularité des circuits modulaires permet d'augmenter la densité d'intégration. Ainsi, dans ces circuits modulaires se pose souvent le problème du délai de propagation des signaux issus d'un module vers celui ou ceux placés en aval et ce problème peut être résolu avantageusement grâce à l'invention.

Ceci est particulièrement le cas pour les additionneurs de type à sélection de retenue (en anglais : "Carry Select Adder") qui peuvent être utilisés dans les processeurs des systèmes informatiques et où il importe de réaliser des additionneurs rapides car ils conditionnent la performance de tout le système.

Aussi l'invention a également pour objet un circuit additionneur de deux nombres de n.p bits du type à sélection de retenue, composé de p modules d'addition, chaque module comprenant :

- deux additionneurs à n bits dont les entrées de retenue sont prépositionnées respectivement à 1 et à 0,

- et un multiplexeur pour sélectionner la sortie de l'un des deux additionneurs,

chaque additionneur comportant une sortie de retenue de type différentiel, chaque module étant associé à un circuit de sélection de retenue fournissant le signal de sélection du multiplexeur du module aval en fonction des bits de retenue issus des deux additionneurs et du signal de sélection fourni par le circuit de sélection amont, caractérisé en ce que chaque additionneur à n bits est conforme au circuit électronique selon l'invention, la sortie binaire de type différentiel étant la sortie de retenue desdits additionneurs.

D'autres caractéristiques et détails de réalisation de l'invention seront exposés dans la suite de la description en relation avec les figures où :

- la figure 1 représente la partie essentielle du circuit électronique permettant la mise en oeuvre de l'invention ;

- la figure 2 est un diagramme permettant d'expliquer les propriétés du circuit de la figure 1 ;

- la figure 3 représente le circuit électronique selon l'invention ;

- la figure 4 représente un mode de réalisation en technologie CMOS du circuit de la figure 3 ;

- la figure 5 représente un montage utilisant le procédé et le circuit électronique selon l'invention ;

- la figure 6 est un chronogramme montrant les signaux d'horloge utilisé dans le montage de la figure 5 ;

- la figure 7 représente un circuit additionneur utilisant le procédé et le circuit électronique selon l'invention ;

- les figures 8 et 9 représentent des réalisations en technologie CMOS d'un circuit de sélection utilisé dans l'additionneur de la figure 7.

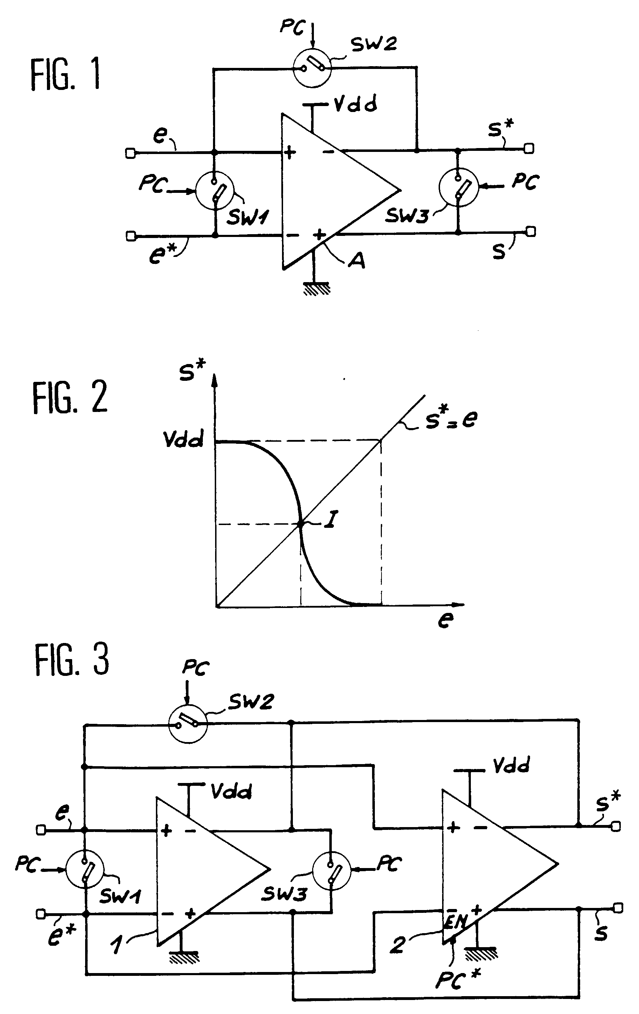

La figure 1 représente sous une forme générale les moyens essentiels permettant la mise en oeuvre de l'invention. Ils comportent un amplificateur différentiel A dont les entrées directe et inverseuse, respectivement e et e*, sont reliées à des lignes de sortie correspondantes d'un circuit non représenté. Les sorties directe et inverseuse, respectivement s et s* sont reliées aux lignes d'entrée correspondantes d'autres circuits non représentés. L'amplificateur A comporte deux bornes d'alimentation reliées respectivement à la masse et à une source de tension d'alimentation Vdd.

Un premier interrupteur SW1 commandé par un signal de précharge PC est branché entre les deux lignes d'entrée de l'amplificateur A. Un second interrupteur SW2 également commandé par PC relie l'une des sorties, par exemple s* à l'une des entrées, par exemple e. Additionnellement, un troisième interrupteur SW3 commandé par PC relie les sorties s et s* entre elles.

Le fonctionnement du circuit de la figure 1 sera maintenant décrit à l'aide du diagramme représenté à la figure 2. Ce diagramme représente les variations de la tension présente sur la sortie inverseuse s* en fonction de la tension appliquée à l'entrée directe e. Dans la suite de la description, nous utiliserons la convention de la logique positive selon laquelle un signal prend la valeur 1 logique lorsque la tension correspondante par rapport à la masse est égale à la tension d'alimentation Vdd, par exemple 5 V et il prend la valeur 0 logique lorsque sa tension est nulle.

Le circuit fonctionne en deux phases : une phase de précharge activée par le signal de commande de précharge PC suivie d'une phase d'évaluation pendant laquelle le signal PC est inactif. Dans ce dernier cas, les interrupteurs SW1, SW2, SW3 sont ouverts et l'amplificateur A fonctionne normalement, c'est-à-dire place ses sorties s et s* respectivement à 5 V et à 0 V ou à 0 V et à 5 V, selon le signe de la différence de potentiel entre ses entrées e et e*.

Pendant la précharge, sous la commande du signal PC, les trois interrupteurs SW1, SW2, SW3 sont fermés. L'amplificateur A débite alors sur ses impédances internes en se plaçant dans un état d'équilibre I représenté sur la figure 2, tel que e=e*=s*=s.

Comme cela apparaît sur le diagramme, le point de fonctionnement I correspond sensiblement à un état où l'amplificateur présente un gain dynamique maximal. Ainsi, lors de l'évaluation suivante, les sorties s et s* seront placées à leur tension d'évaluation avec le maximum de rapidité. De plus, cette propriété est conservée indépendamment du dimensionnement de l'amplificateur et donc indépendamment des dispersions de fabrication dans le cas des circuits intégrés.

La figure 3 représente une variante de réalisation du circuit de la figure 1 et constitue la présente invention. Cette variante est avantageuse pour le cas où il est nécessaire de réduire la consommation de l'amplificateur pendant la phase de précharge. Pour cela, l'amplificateur A est remplacé par deux amplificateurs 1,2 montés en parallèle. Le premier amplificateur 1 est dimensionné de façon à présenter des impédances internes relativement élevées. L'amplificateur 2 est un amplificateur à trois états présentant des impédances internes plus faibles. L'amplificateur 2 possède une entrée de validation EN permettant sa mise à l'état de haute impédance.

Comme précédemment, l'interrupteur SW1 relie les entrées e, e* entre elles, l'interrupteur SW2 relie une sortie s* à une entrée e et l'interrupteur SW3 relie les sorties s, s* entre elles, ces trois interrupteurs étant commandés par le signal de précharge PC.

Le circuit de la figure 3 fonctionne de la façon suivante. Pendant le phase de précharge, le signal PC est actif et les interrupteurs SW1, SW2, SW3 sont fermés. D'autre part, le signal PC*, complément de PC, appliqué à l'entrée de validation EN de l'amplificateur 2 place ce dernier à l'état de haute impédance. Il en résulte que l'amplificateur 2 n'est la source d'aucune consommation. Comme dans la réalisation précédente, l'amplificateur 1 effectue la précharge des lignes d'entrée et de sortie à une tension d'équilibre voisine de la moitié de la tension d'alimentation Vdd.

Pendant la phase d'évaluation suivante, PC=0 et PC*=1. Les trois interrupteurs sont alors ouverts et l'amplificateur 2 est actif. Comme précédemment, au début de chaque phase d'évaluation, les deux amplificateurs sont placés dans un état où ils présentent pratiquement un maximum de gain dynamique.

Il convient de noter que le dimensionnement des deux amplificateurs dépendra de la technologie et du contexte d'utilisation de l'invention. En particulier, les valeurs des impédances internes de l'amplificateur 1 devront être choisies suffisamment grandes pour limiter la température à un niveau qui convienne au bon fonctionnement du circuit et suffisamment faibles pour que la précharge des lignes soit terminée au plus tard à la fin de la phase de précharge. Ce choix dans chaque cas particulier est à la portée de l'homme du métier et ne nécessite donc pas de développements supplémentaires.

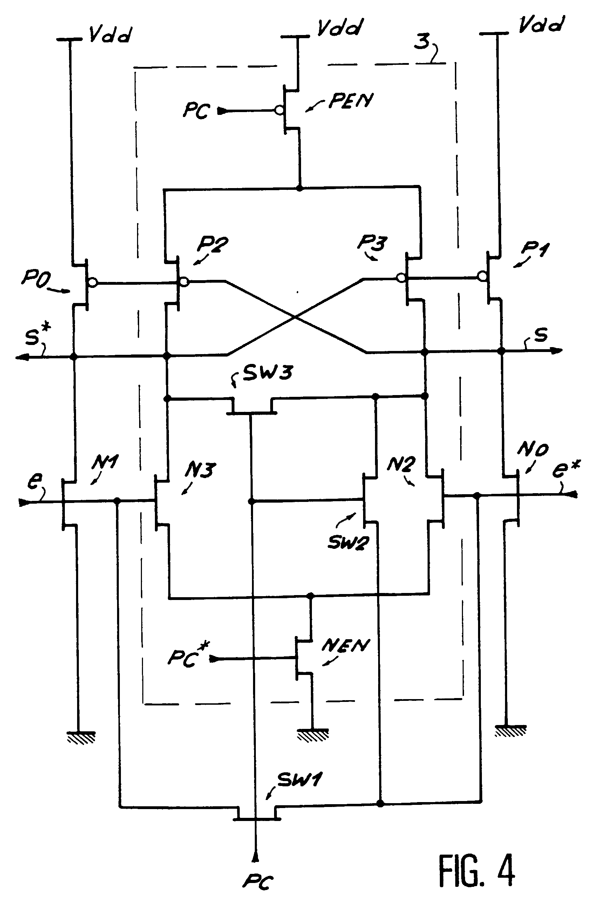

La figure 4 représente une réalisation en technologie CMOS du circuit de la figure 3. L'amplificateur 1 est composé des transistors PMOS P0, P1 et des transistors NMOS N0, N1. Les transistors P0 et N1, respectivement P1 et N0, sont branchés en série entre la masse et la tension d'alimentation Vdd. Les grilles des transistors N1 et N0 constituent respectivement les entrées e et e*. Les drains des transistors N0 et P1 constituent la sortie s, tandis que les drains des transistors P0 et N1 constituent la sortie s*. Les sorties s et s* sont reliées respectivement aux grilles des transistors P0 et P1.

Le sous-ensemble 3 de la figure 4 inclut l'amplificateur 2 ainsi que les interrupteurs SW2 et SW3. L'amplificateur 2 est constitué des transistors PMOS P2, P3 et des transistors NMOS N2, N3. De même que pour l'amplificateur 1, les transistors P2 et N3, respectivement P3 et N2, sont branchés en série. Les grilles des transistors N3 et N2 sont respectivement reliées aux entrées e et e*. Les drains des transistors P3 et N2 sont reliés à la sortie s et les drains des transistors P2 et N3 sont reliés à la sortie s*. Les sorties s et s* sont reliées respectivement aux grilles des transistors P2 et P3. Les sources des transistors P2 et P3 sont reliées à la tension d'alimentation Vdd par l'intermédiaire d'un transistor PMOS PEN dont la grille reçoit le signal de précharge PC. Les sources des transistors N2 et N3 sont reliées à la masse par l'intermédiaire d'un transistor NMOS NEN dont la grille reçoit le signal PC*.

Les entrées e et e* sont reliées entre elles par l'intermédiaire du chemin drain-source d'un transistor NMOS SW1. La sortie s est reliée à l'entrée e* par l'intermédiaire du chemin drain-source d'un transistor NMOS SW2. Les sorties s et s* sont reliées entre elles par l'intermédiaire du chemin drain-source du transistor NMOS SW3. Les trois transistors SW1, SW2 et SW3 reçoivent sur leur grille le signal de précharge PC.

Le fonctionnement du circuit de la figure 4 se déduit aisément du schéma. Pendant la phase de précharge, le signal PC possède une tension positive et les transistors SW1, SW2, SW3 sont conducteurs tandis que les transistors NEN et PEN sont bloqués. Ainsi, l'amplificateur 2 est déconnecté de son alimentation. Par contre, les transistors P0 et N1 d'une part et P1 et N0 d'autre part constituent des diviseurs de tensions grâce à l'état résistant de leur chemin drain-source qui est partiellement conducteur.

En fin de précharge, le signal PC repasse à 0 et le signal PC* repasse à une tension positive. Par conséquent, les transistors SW1, SW2, SW3 s'ouvrent et les transistors NEN et PEN se ferment. Les deux amplificateurs 1, 2 fonctionnent alors normalement en amplificateurs différentiels.

Il convient de noter que les impédances internes et le gain en puissance des amplificateurs sont conditionnés par la résistance des chemins drain-source des transistors qui les constituent. Ces résistances peuvent être ajustées par un dimensionnement approprié des transistors, en particulier par le choix de leur largeur.

Comme variante de réalisation, on peut remplacer les transistors NMOS constituant des interrupteurs SW1, SW2, SW3 par des portes de transfert CMOS. Dans ce cas, on branche en parallèle, sur chaque transistor NMOS, un transistor PNOS dont la grille reçoit le signal PC*. Cette modification permet d'améliorer l'effet de court-circuit des interrupteurs.

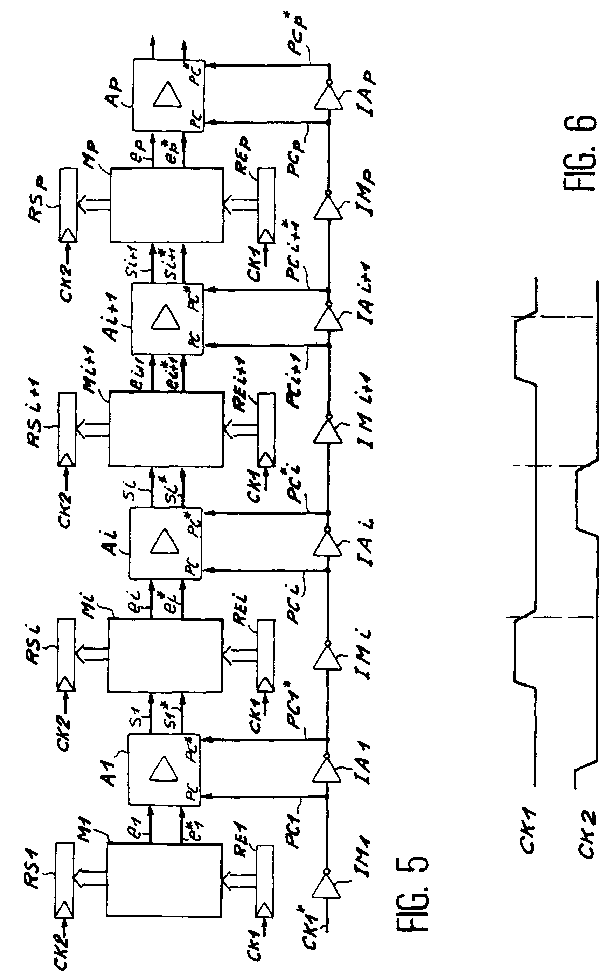

La figure 5 représente un montage où l'invention est mise en application. Ce montage comprend une pluralité de circuits M1, Mi, Mi+1, Mp. Chaque circuit, par exemple Mi, reçoit au moins un signal différentiel s1, s1* issu d'au moins un circuit placé en amont et fournit au moins une sortie différentielle ei, ei* destinée à au moins un circuit Mi+1 placé en aval.

La transmission de chaque signal différentiel ei, ei* issu d'un circuit Mi vers le circuit en aval Mi+1 est effectué par l'intermédiaire d'un amplificateur différentiel Ai conformément à l'invention. Ainsi, la sortie différentielle ei, ei* d'un des circuits Mi sert d'entrée à l'amplificateur Ai qui fournit en sortie le signal différentiel si, si* appliqué à l'entrée d'un des circuits en aval Mi+1.

Chaque circuit possède généralement d'autres entrées et d'autres sorties leur permettant de prendre en compte des variables d'entrée et de fournir des résultats. On a supposé par simplification que ces données étaient respectivement dans des registres d'entrée RE1, REi, REi+1, REp et de sortie RS1, RSi, RSi+1, RSp.

Le montage est synchronisé par des signaux d'horloge CK1 et CK2 représentés à la figure 6. En position haute, les signaux CK1 et CK2 sont actifs et verrouillent respectivement les registres d'entrée REi et de sortie RSi. Par conséquent, la précharge des lignes ei, ei* peut débuter avec le front montant du signal CK1 mais l'évaluation suivante doit être terminée avant le front descendant du signal CK2 suivant.

Selon une particularité avantageuse du montage, il est prévu un ensemble d'inverseurs IM1, IA1, IMi, IAi, IMi+1, IAi+1, IMp, IAp montés en cascade dont le premier IM1 reçoit le complément CK1* du signal d'horloge CK1. Chaque inverseur IMi ou IAi est associé respectivement à un circuit Mi ou à un amplificateur Ai. L'entrée PCi et/ou la sortie PCi* d'un inverseur IAi associé à un amplificateur Ai fournissent des signaux utilisés pour commander la précharge de l'amplificateur Ai associé à l'inverseur IAi.

Le montage de la figure 5 fonctionne de la façon suivante. Lorsque le signal d'horloge CK1 devient actif, les signaux de précharge PCi, PCi* se propagent d'amont en aval par l'intermédiaire des inverseurs IMi, IAi. Les amplificateurs Ai vont donc effectuer les uns après les autres la précharge des lignes différentielles. Simultanément, les signaux d'entrée sont chargés dans les registres d'entrée REi.

Lorsque CK1 repasse à 0, les signaux PCi et PCi* vont changer d'état avec un retard fonction du nombre d'inverseurs que le signal d'entrée CK1* doit traverser. Il en résulte que les signaux différentiels ei, ei* sont évalués d'amont en aval en synchronisme avec le changement d'état des signaux de précharge PCi et PCi*. Grâce à un choix convenable de la technologie utilisée et/ou de la fréquence des signaux d'horloge, l'évaluation sera terminée dans chaque circuit avant le front descendant du signal CK2 suivant qui définit également la fin du verrouillage des résultats dans les registres RSi.

Bien entendu, chaque inverseur IMi, IAi est dimensionné de façon à provoquer un retard au moins égal au temps de commutation du circuit Mi ou de l'amplificateur Ai associé. Grâce à cette disposition, chaque amplificateur ne passe pas de sa phase de précharge à sa phase active avant que le signal différentiel présent à son entrée ne soit évalué et cette propriété se conserve malgré les dispersions de fabrication. Ceci évite en particulier qu'un amplificateur amplifie ses lignes d'entrée avant qu'elles ne présentent une tension différentielle suffisante et correspondant à la vraie variable logique à amplifier. Dans le cas contraire, l'amplificateur pourrait être déplacé de son point de fonctionnement optimal, ce qui augmenterait son temps de commutation.

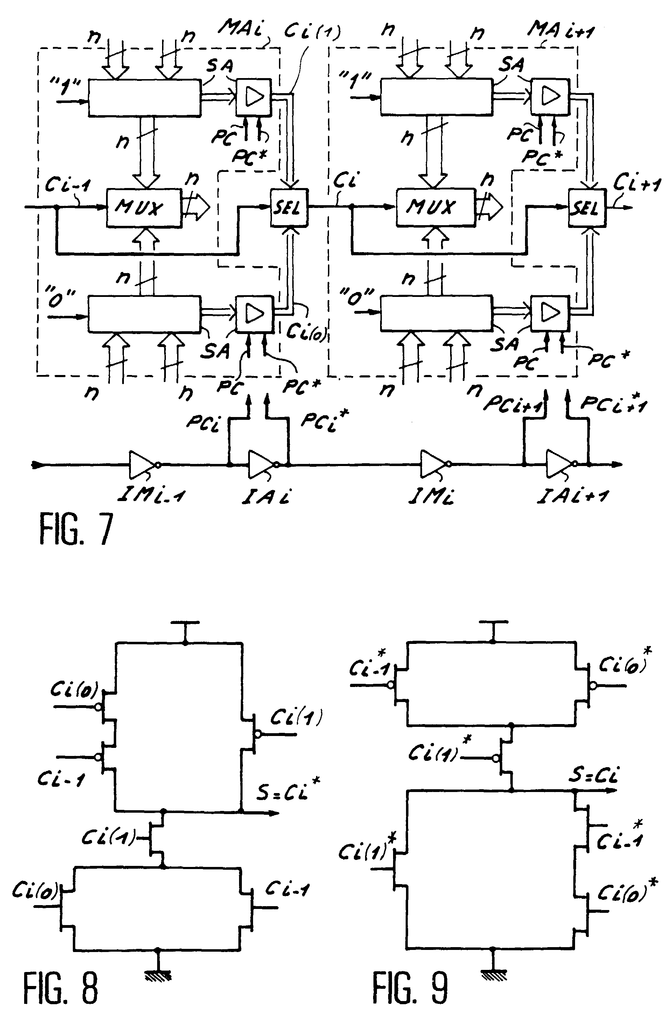

La figure 7 représente une partie d'un additionneur de type à sélection de retenue. Ce genre d'additionneur est connu en soi et pour plus de détail, on peut se référer au livre intitulé "Computer Arithmetic - Principle, Architecture and Design", KAI HWANG, publié par John Wiley and Sons 1979, pages 81 à 84. Ainsi, comme représenté sur la figure 7, pour réaliser un additionneur de deux nombres de n.p bits, on prévoit p modules d'addition MAi, MAi+1, où chaque module d'addition sauf le premier comprend deux additionneurs SA à n bits dont les entrées de retenue sont prépositionnées respectivement à 1 et à 0 et un multiplexeur MUX pour sélectionner la sortie à n bits de l'un des deux additionneurs. Chaque module d'addition MAi est associé à un circuit de sélection de retenue SEL qui fournit un signal de sélection Ci du multiplexeur MUX du module aval MAi+1 en fonction des bits de retenue Ci (1), Ci (0) issus des deux additionneurs et du signal de sélection Ci-1 fourni par le circuit de sélection amont. Le premier module d'addition correspondant aux poids faibles des nombres est quant à lui constitué d'un seul additionneur à n bits recevant le signal de retenue d'entrée pour l'opération considérée.

Par rapport à d'autres types d'additionneurs, tels que ceux à anticipation de retenue (en anglais : "Carry lookahead"), les additionneurs à sélection de retenue présentent l'avantage d'une disposition modulaire, donc régulière, favorisant une intégration à haute densité. Cependant, la rapidité du montage dépend de la rapidité des additionneurs SA et du temps de propagation des retenues. La rapidité de l'additionneur SA dépend de sa conception, en particulier si on le choisit du type à propagation de retenue (en anglais "Ripple Carry Adder"), elle dépendra du nombre n de bits des nombres qu'il traite. D'autre part, le temps de propagation des retenues dépendra du nombre p de modules MAi. Aussi, par exemple, pour réaliser un additionneur à 64 bits, on pourra choisir une organisation de 4 modules de 16 bits et dans ce cas, le temps d'exécution d'une addition sera égal au temps d'exécution d'une addition de 16 bits dans un additionneur SA auquel s'ajoute le temps de propagation de trois retenues. Par conséquent, pour bénéficier des facilités d'intégration tout en conservant une rapidité comparable aux autres solutions, il conviendra de réduire au maximum le temps de propagation des retenues.

Une première approche consiste à utiliser des additionneurs SA fournissant une sortie de retenue de type différentiel. Avantageusement, et selon l'invention, cette sortie de retenue différentielle est transmise au circuit de sélection associé par l'intermédiaire d'un amplificateur différentiel conformément à la description précédente.

Comme pour le montage de la figure 5 et pour les mêmes raisons, on peut utiliser deux signaux d'horloge CK1 et CK2 pour verrouiller respectivement des registres d'entrée (non représentés) contenant les opérandes et des registres placés en sortie des multiplexeurs pour contenir le résultat. De même, la précharge est effectuée au moyen d'une série d'inverseurs montés en cascade IMi-1, IAi, IMi, IAi+1. Chaque inverseur IAi est associé à un module d'addition MAi et fournit les signaux de commande de précharge PCi et/ou PCi* des deux amplificateurs différentiels du module. Chaque circuit de sélection SEL est associé à un inverseur IMi dimensionné pour provoquer un retard de propagation des signaux de précharge égal au temps de commutation du circuit de sélection associé.

Le circuit additionneur de la figure 7 fonctionne de la façon suivante. Pendant la phase de précharge, les amplificateurs différentiels sont commandés en mode de précharge par les signaux de commande de précharge PCi, PCi* associés. Pendant la phase d'évaluation suivante, les signaux de retenue sont amplifiés par les amplificateurs différentiels. Ces signaux amplifiés sont reçus par le circuit de sélection SEL qui fournit le signal Ci de commande du multiplexeur aval. Le même signal Ci est transmis au circuit de sélection aval.

A titre d'illustration de mise en oeuvre, nous allons décrire en référence aux figures 8 et 9 des circuits de sélections réalisés en technologie CMOS. Le signal Ci issu du circuit de sélection associé au module MAi doit vérifier l'équation logique suivante :

$$Ci = Ci(1) \cdot [Ci-1 + Ci(0)],$$

où Ci(1) représente la retenue de sortie de l'additionneur SA dont l'entrée de retenue est prépositionnée à 1, Ci(0) représente la retenue de sortie de l'additionneur SA dont l'entrée de retenue est prépositionnée à 0 et Ci-1 représente le signal de sortie du circuit de sélection associé au module amont.

En pratique, il est plus facile de réaliser la fonction complémentaire, c'est-à-dire Ci*, comme représenté à la figure 8. Il conviendrait donc en principe de brancher à la sortie S de ce circuit un inverseur. Or, il est possible d'éviter ce circuit supplémentaire en utilisant en alternance le circuit de la figure 8 sans inverseur et le circuit représenté à la figure 9 qui réalise la fonction logique :

$$S = Ci(1)^* + [Ci\text{-}1^* . Ci(0)^*] = Ci,$$

où Ci(1)*, Ci-1* et Ci(0)* sont les compléments des signaux définis précédemment.

Bien entendu, dans chaque module recevant le signal de sélection complémentaire ci*, le prépositionnement des retenues d'entrée des additionneurs SA devra être inversé. On peut remarquer enfin qu'une seule des lignes de sortie des amplificateurs (la sortie directe ou inverseuse selon le cas) est utilisée à l'entrée des circuits de sélection.

Selon une deuxième approche pour augmenter la rapidité de l'additionneur, on peut aussi appliquer le procédé selon l'invention dans chacun des additionneurs élémentaires SA utilisés dans les modules d'addition MAi. Pour cela, on peut par exemple utiliser des additionneurs SA à propagation de retenue de type différentiel dont la propagation est effectuée par l'intermédiaire d'amplificateurs différentiels selon une disposition conforme à la figure 5 où chaque module Mi est par exemple un simple additionneur à quatre bits à propagation de retenue. Dans ce cas, le montage d'inverseurs IMi, IAi pourra être commun à plusieurs ou à tous les additionneurs SA du circuit.

## Revendications

1. Procédé pour transférer une information binaire de type différentiel présente sur deux premières lignes de bit (e, e*) vers deux secondes lignes de bit (s, s*) distinctes desdites premières lignes de bit (e, e*) par l'intermédiaire d'un amplificateur différentiel (A) connecté entre les premières et les secondes lignes de bit, ledit procédé comportant une phase de précharge suivie d'une phase d'évaluation desdites premières lignes de bit, ledit procédé étant caractérisé en ce qu'il consiste à utiliser en tant qu'amplificateur différentiel (A) un premier amplificateur différentiel (1) possédant de fortes impédances internes de sortie et un second amplificateur différentiel (2) à trois états possédant de faibles impédances internes de sortie, en ce que les entrées, respectivement, les sorties desdits premier et second amplificateurs différentiels sont branchées en parallèle, en ce que ladite phase de précharge consiste à mettre en court-circuit lesdites premières lignes de bit entre elles et à mettre en court-circuit au moins une desdites secondes lignes de bit avec lesdites premières lignes de bit et en ce que ledit second amplificateur différentiel (2) est mis à l'état de haute impédance pendant ladite phase de précharge.

2. Procédé selon la revendication 1, caractérisé en ce que pendant la phase de précharge, les secondes lignes de bit sont mises en court-circuit entre elles.

3. Circuit électronique comportant au moins une entrée binaire de type différentiel constituée de deux premières lignes de bit (e, e*) reliées à l'entrée d'un amplificateur différentiel (A), et une sortie binaire de type différentiel constituée de deux secondes lignes de bit (S, S*) reliées à la sortie de l'amplificateur différentiel, lesdites premières lignes de bit étant préchargées à une tension déterminée pendant une phase de précharge suivie d'une phase d'évaluation, caractérisé en ce que ledit amplificateur différentiel (A) est constitué d'un premier amplificateur différentiel (1) à fortes impédances internes de sortie et d'un second amplificateur différentiel (2) à trois états à faibles impédances internes de sortie, les entrées, respectivement, les sorties desdits premier et second amplificateurs différentiels étant branchées en parallèle, en ce que ledit circuit comprend des premiers moyens (SW1) pour court-circuiter lesdites deux premières lignes de bit (e,e*) et des seconds moyens (SW2) pour court-circuiter au moins une des lignes de sortie de l'amplificateur différentiel (A) avec au moins une des premières lignes de bit (e, e*), lesdits premiers et seconds moyens étant activés pendant ladite phase de précharge et désactivés pendant ladite phase d'évaluation et en ce que ledit second amplificateur différentiel (2) est mis à l'état de haute impédance pendant ladite phase de précharge.

4. Circuit électronique selon la revendication 3, caractérisé en qu'il comprend des troisièmes moyens (SW3) pour court-circuiter entre elles les deux lignes de sortie (s, s*) des amplificateurs différentiels (1, 2).

5. Circuit électronique selon la revendication 4, caractérisé en ce que lesdits premier et second amplificateurs différentiels (1, 2) sont réalisés en technologie CMOS.

6. Circuit électronique selon la revendication 5, caractérisé en ce que les valeurs des impédances internes desdits premier et second amplificateurs (1, 2) sont définies par la largeur des transistors MOS constituant lesdits amplificateurs.

7. Montage comprenant une pluralité de circuits (Mi) branchés en cascade, chaque circuit fournissant en sortie à au moins un circuit placé en aval (Mi+1) au moins une information binaire (ei, ei*) de type différentiel, chaque circuit étant branché au circuit en aval par l'intermédiaire d'un circuit électronique (A$_i$), caractérisé en ce que chacun desdits circuits électroniques (A$_i$) est conforme à l'une des revendications 3 à 6.

8. Montage selon la revendication 7, caractérisé en ce qu'il comporte une pluralité d'inverseurs (IMi, IAi) branchés en cascade et associés respectivement aux circuits (Mi) et aux circuits électroniques (Ai) constituant ledit montage, en ce que le premier desdits inverseurs (IM$_1$) reçoit en entrée un signal d'horloge (CK1*) et en ce que lesdites phases de précharge et d'évaluation de chaque circuit électronique (Ai) sont commandées par les signaux d'entrée (PCi) et/ou de sortie (PCi*) de l'inverseur (IAi) associé audit circuit électronique (Ai).

9. Circuit additionneur de deux nombres de n.p bits du type à sélection de retenue, composé de p modules d'addition (MAi), chaque module comprenant :

- deux additionneurs (SA) à n bits dont les entrées de retenue sont prépositionnées respectivement à 1 et à 0,

- et un multiplexeur (MUX) pour sélectionner la sortie de l'un des deux additionneurs,

chaque additionneur comportant une sortie de retenue de type différentiel, chaque module (MAi) étant associé à un circuit de sélection de retenue (SEL) fournissant le signal de sélection (Ci) du multiplexeur (MUX) du module aval (MAi+1) en fonction des bits de retenue (Ci(1), Ci(0)) issus des deux additionneurs et du signal de sélection (Ci-1) fourni par le circuit de sélection associé au module amont, caractérisé en ce que chaque additionneur (SA) à n bits comprend un circuit électronique selon l'une des revendications 3 à 6, la sortie binaire de type différentiel étant la sortie de retenue desdits additionneurs.

10. Circuit additionneur selon la revendication 9, caractérisé en ce qu'il comporte une pluralité d'inverseurs (IMi-1, IAi) branchés en cascade et associés aux circuits de sélection et aux circuits électroniques d'un même module d'addition, en ce que le premier desdits inverseurs reçoit en entrée un signal d'horloge (CK1) et en ce que lesdites phases de précharge et d'évaluation d'un circuit électronique sont commandées par les signaux d'entrée (PCi) et/ou de sortie (PCi*) de l'inverseur associé audit circuit électronique.

## Patentansprüche

1. Verfahren zum Übertragen einer binären Information des differentiellen Typs, die auf zwei ersten Bitleitungen (e, e*) vorhanden ist, an zwei zweite Bitleitungen (s, s*), die von den ersten Bitleitungen (e, e*) verschieden sind, über einen Differenzverstärker (A), der an die ersten und die zweiten Bitleitungen angeschlossen ist, wobei das Verfahren eine Vorladungsphase enthält, der eine Phase der Auswertung der ersten Bitleitungen folgt, wobei das Verfahren dadurch gekennzeichnet ist, daß es darin besteht, als Differenzverstärker (A) einen ersten Differenzverstärker (1), der hohe interne Ausgangsimpedanzen besitzt, sowie einen zweiten Differenzverstärker (2) mit drei Zuständen, der niedrige interne Ausgangsimpedanzen besitzt, zu verwenden, daß die Eingänge bzw. die Ausgänge der ersten und zweiten Differenzverstärker parallelgeschaltet sind, daß die Vorladungsphase darin besteht, die ersten Bitleitungen miteinander kurzzuschließen und wenigstens eine der zweiten Bitleitungen mit den ersten Bitleitungen kurzzuschließen, und daß der zweite Differenzverstärker (2) während der Vorladungsphase in den Zustand hoher Impedanz versetzt wird.

2. Verfahren nach Anspruch 1, dadurch gekennzeichnet, daß während der Vorladungsphase die zweiten Bitleitungen miteinander kurzgeschlossen sind.

3. Elektronische Schaltung, mit wenigstens einem binären Eingang des differentiellen Typs, der aus zwei ersten Bitleitungen (e, e*) gebildet ist, die mit dem Eingang eines Differenzverstärkers (A) verbunden sind, und einem binären Ausgang des differentiellen Typs, der aus zwei zweiten Bitleitungen (s, s*) gebildet ist, die mit dem Ausgang des Differenzverstärkers verbunden sind, wobei die ersten Bitleitungen während einer Vorladungsphase, der eine Auswertungsphase folgt, auf eine bestimmte Spannung vorgeladen werden, dadurch gekennzeichnet, daß der Differenzverstärker (A) aus einem ersten Differenzverstärker (1) mit hohen internen Ausgangsimpedanzen sowie aus einem zweiten Differenzverstärker (2) mit drei Zuständen mit niedrigen internen Ausgangsimpedanzen gebildet ist, wobei die Eingänge bzw. die Ausgänge der ersten und zweiten Differenzverstärker parallelgeschaltet sind, daß die Schaltung erste Mittel (SW1) zum Kurzschließen der zwei ersten Bitleitung (e, e*) sowie zweite Mittel (SW2) zum Kurzschließen wenigstens einer der Ausgangsleitungen des Differenzverstärkers (A) mit wenigstens einer der ersten Bitleitungen (e, e*) enthält, wobei die ersten und zweiten Mittel während der Vorladungsphase aktiviert und während der Auswertungsphase deaktiviert sind, und daß der zweite Differenzverstärker (2) während der Vorladungsphase in den Zustand hoher Impedanz versetzt wird.

4. Elektronische Schaltung nach Anspruch 3, dadurch gekennzeichnet, daß sie dritte Mittel (SW3) zum Kurzschließen der zwei Ausgangsleitungen (s, s*) der Differenzverstärker (1, 2) miteinander enthält.

5. Elektronische Schaltung nach Anspruch 4, dadurch gekennzeichnet, daß die ersten und zweiten Differenzverstärker (1, 2) in CMOS-Technologie verwirklicht sind.

6. Elektronische Schaltung nach Anspruch 5, dadurch gekennzeichnet, daß die Werte der internen Impedanzen der ersten und zweiten Verstärker (1, 2) durch die Breite der die Verstärker bildenden MOS-Transistoren definiert sind.

7. Anordnung mit mehreren in Kaskade geschalteten Schaltungen (Mi), wobei jede Schaltung an ihrem Ausgang an wenigstens eine dahinter angeordnete Schaltung (Mi + 1) wenigstens eine binäre Information (ei, ei*) des differentiellen Typs liefert, wobei jede Schaltung mit der dahinter befindlichen Schaltung über eine elektronische Schaltung (Ai) verbunden ist, dadurch gekennzeichnet, daß jede der elektronischen Schaltungen (Ai) durch einen der Ansprüche 3 bis 6 definiert ist.

8. Anordnung nach Anspruch 7, dadurch gekennzeichnet, daß sie mehrere Invertierer (IMi, IAi) enthält, die in Kaskade geschaltet und den Schaltungen (Mi) bzw. den elektronischen Schaltungen (Ai), die die Anordnung bilden, zugeordnet sind, daß der erste der Invertierer (IM1) an seinem Eingang ein Taktsignal (CK1*) empfängt und daß die Vorladungs- und Auswertungsphasen jeder elektronischen Schaltung (Ai) durch die Eingangssignale (PCi) und/oder die Ausgangssignale (PCi*) des der elektronischen Schaltung (Ai) zugeordneten Invertierers (IAi) gesteuert werden.

9. Schaltung zum Addieren zweier Zahlen aus n p Bits des Typs mit Übertragauswahl, die aus p Additionsmodulen (MAi) aufgebaut ist, wobei jedes Modul enthält:

- zwei Addierer (SA) mit n Bits, deren Übertrageingänge im voraus auf Eins bzw. auf Null gesetzt sind,

- und einen Multiplexierer (MUX), der das Ausgangssignal eines der zwei Addierer auswählt,

wobei jeder Addierer einen Übertragausgang des differentiellen Typs enthält, wobei jedes Modul (MAi) einer Übertragauswahlschaltung (SEL) zugeordnet ist, die das Auswahlsignal (Ci) des Multiplexierers (MUX) des nachfolgenden Moduls (MAi + 1) in Abhängigkeit von den Übertragbits (Ci(1), Ci(0)), die von den zwei Addierern ausgegeben werden, und vom Auswahlsignal (Ci-1), das von der dem vorangehenden Modul zugeordneten Auswahlschaltung geliefert wird, liefert, dadurch gekennzeichnet, daß jeder Addierer (SA) mit n Bits eine elektronische Schaltung nach einem der Ansprüche 3 bis 6 enthält, wobei der binäre Ausgang des differentiellen Typs der Übertragausgang der Addierer ist.

10. Addiererschaltung nach Anspruch 9, dadurch gekennzeichnet, daß sie mehrere Invertierer (IMi, IAi) besitzt, die in Kaskade geschaltet und den Auswahlschaltungen sowie den elektronischen Schaltungen desselben Additionsmoduls zugeordnet sind, daß der erste der Invertierer an seinem Eingang ein Taktsignal (CK1) empfängt, und daß die Vorladungs- und Auswertungsphasen einer elektronischen Schaltung durch die Eingangssignale (PCi) und/oder die Ausgangssignale (PCi*) des der elektronischen Schaltung zugeordneten Invertierers gesteuert werden.

## Claims

1. A method for transferring a binary information of the differential type present on two first bit lines (e, e*) to two second bit lines (s, s*) separate from said first bit lines (e, e*) through a differential amplifier (A) connected between the first and second bit lines, said method comprising a precharging phase followed by a phase of evaluation of said first bit lines, said method being characterised in that it consists in using as differential amplifier (A) a first differential amplifier (1) having high internal output impedances, and a second differential amplifier (2) with three states having low internal output impedances, in that the inputs on one hand and the outputs on the other hand of said first and second differential amplifiers are connected in parallel, and in that said precharging phase consists of short-circuiting said first bit lines to each other and of short-circuiting at least one of said second bit lines to said first bit lines and in that said second differential amplifier (2) is placed in a state of high impedance during said precharging phase.

2. A method according to claim 1, characterised in that said second bit lines are short-circuited to each other during said precharging phase.

3. An electronic circuit comprising at least one binary input of the differential type consisting of two first bit lines (e, e*) connected to the input of a differential amplifier (A), and a binary output of the differential type consisting of two second bit lines (s, s*) connected to the output of the differential amplifier, said first bit lines being precharged to a given voltage during a precharging phase which is followed by an evaluation phase, characterised in that said differential amplifier (A) consists of a first differential amplifier (1) having high internal output impedances and a second differential amplifier (2) with three states having low internal output impedances, the inputs on one hand and the outputs on the other hand of said first and second differential amplifiers being connected in parallel, and in that said circuit comprises first means (SW1) for short-circuiting both said first bit lines and second means (SW2) for short-circuiting at least one of the output lines of the differential amplifier (A) to at least one of the first bit lines (e, e*), said first and second means being activated during said precharging phase and not activated during said evaluation phase, and in that said second differential amplifier (2) is placed in a state of high impedance during said precharging phase.

4. An electronic circuit according to claim 3, characterised in that it comprises third means (SW3) for short-circuiting to each other the two output lines (s, s*) of the differential amplifiers (1, 2).

5. An electronic circuit according to claim 4, characterised in that said first and second differential amplifiers (1, 2) are made by CMOS technology.

6. An electronic circuit according to claim 5, characterised in that the values of the internal impedances of said first and second amplifiers (1, 2) are defined by the width of the MOS transistors of which said amplifiers are made.

7. An assembly comprising a plurality of circuits (Mi) connected in cascade, each circuit furnishing at its output to at least one downstream circuit (Mi+1) at least one element of binary information (ei, ei*) of differential type, each circuit being connected to the downstream circuit through an electronic circuit (Ai), characterised in that each of said electronic circuits (Ai) is in accordance with one of claims 3 to 6.

8. An assembly according to claim 7, characterised in that it comprises a plurality of inverters (IMi, IAi) connected in cascade and associated respectively with the circuits (Mi) and with the electronic circuits (Ai) comprising said assembly, and in that the first one of said inverters ($IM_1$) receives an input clock signal (CK1*) and in that said precharging and evaluation phases of each electronic circuit (Ai) are controlled by one of the input signals (PCi) and / or one of the output signals (PCi*) of the inverter (IAi) associated with said electronic circuit (Ai).

9. An adder circuit of the carry select type for two numbers having n x p bits composed of p addition modules (MAi), each module comprising:

   - two n bit adders (SA) whose carry inputs are pre-positioned at 1 and at 0 respectively,

   - and a multiplexer (MUX) for selecting the output of one of the two adders,

   each adder comprising a carry output of differential type, each module (MAi) being associated with a carry select circuit (SEL) for furnishing the carry select signal (Ci) for the multiplexer (MUX) of the downstream module (MAi+1) as a function of the carry bits (Ci(1), Ci(0)) from the two adders and of the select signal (Ci-1) provided by the selection circuit associated with the upstream module, characterised in that each n-bit adder (SA) comprises an electronic circuit according to one of claims 3 to 6, the binary output of differential type being the carry output of said adders.

10. An adder circuit according to claim 9, characterised in that it comprises a plurality of inverters (IMi-1, IAi) connected in cascade and associated with the selection circuits and with the electronic circuits of the same adder module, in that the first one of said inverters receives an input clock signal (CK1) and in that said precharging and evaluation phases of an electronic circuit are controlled by the input signals (PCi) and / or the output signals (PCi*) of the inverter associated with said electronic circuit.

FIG. 1

FIG. 2

FIG. 3

FIG. 4

EP 0 488 893 B1

FIG. 5

FIG. 6

FIG. 7

FIG. 8

FIG. 9